# EUROPÄISCHE PATENTSCHRIFT

(11) **EP 2 188 852 B1**
(45) Veröffentlichungstag und Bekanntmachung des Hinweises auf die Patenterteilung: **26.04.2017**
(21) Anmeldenummer: 08827587.0
(22) Anmeldetag: 11.08.2008
(51) Int. Cl.: H01L 33/00

(54) **OPTOELEKTRONISCHES HALBLEITERMODUL UND VERFAHREN ZUR HERSTELLUNG EINES SOLCHEN**
OPTO-ELECTRONIC SEMICONDUCTOR MODULE AND METHOD FOR THE PRODUCTION THEREOF
MODULE À SEMI-CONDUCTEUR OPTO-ÉLECTRONIQUE ET PROCÉDÉ DE FABRICATION ASSOCIÉ

(30) Priorität: 20.08.2007 DE 102007039291
(43) Veröffentlichungstag der Anmeldung: 26.05.2010
(73) Patentinhaber: OSRAM Opto Semiconductors GmbH, 93055 Regensburg (DE)
(72) Erfinder: KÖHLER, Steffen, 93049 Regensburg (DE); ENGL, Moritz, 93055 Regensburg (DE); SINGER, Frank, 93128 Regenstauf (DE); GRÖTSCH, Stefan, 93077 Lengfeld - Bad Abbach (DE); ZEILER, Thomas, 93152 Nittendorf (DE); WEISS, Mathias, 07743 Jena (DE)
(74) Vertreter: Epping - Hermann - Fischer
(86) Internationale Anmeldenummer: PCT/DE2008/001327
(87) Internationale Veröffentlichungsnummer: WO 2009/024125

(56) Entgegenhaltungen:
- EP-A- 1 804 303
- DE-C1- 19 508 222
- JP-A- 2006 135 276
- US-A- 5 820 648
- US-A1- 2005 062 055
- PROHASKA; MILLER: "Aluminum Nitride: A Review of the Knowledge Base for Physical Property Development", MRS PROCEEDINGS, vol. 167, 1 January 1989 (1989-01-01), pages 215-227, XP055283504, ISSN: 2059-8521, DOI: 10.1557/PROC-167-215
- YONGDA ET AL.: "The study on pad of AlN multilayer cofire ceramic substrate", ELECTRONIC PACKAGING TECHNOLOGY PROCEEDINGS, 2003. ICEPT2003. FIFTH IN TERNATIONAL CONFERENCE ON SHANGHAI, CHINA OCT. 28-30, 2003, PISCATAWAY, NJ, USA,IEEE, 28 October 2003 (2003-10-28), pages 340-342, XP032165386, DOI: 10.1109/EPTC.2003.1298755 ISBN: 978-0-7803-8168-1

## Beschreibung

Die Erfindung betrifft ein optoelektronisches Halbleitermodul und ein Verfahren zur Herstellung eines optoelektronischen Halbleitermoduls.
US 2005/0062055 A1 beschreibt eine Anordnung eines Lasers auf einem Träger. Auf dem Träger ist über dem Laser eine Kappe befestigt, die ein mit einer Öffnung versehenes Siliziumsubstrat und eine strahlungsdurchlässige Schichtfolge aus einer Ätzstoppschicht, einer dünnen Polysiliziumschicht, einer eingeebneten TEOS-Schicht und einer verstärkenden Glasschicht aufweist. In der Ebene der TEOS-Schicht kann eine Linse angeordnet sein.

DE 19508222 C1 beschreibt einen optoelektronischen Wandler und ein zugehöriges Herstellungsverfahren. Optoelektronische Halbleiterbauelemente werden in Vertiefungen einer Bodenplatte, die durch Stege getrennt sind, angeordnet und abgedeckt. Hierzu werden Abstandshalter auf den Stegen und ein Linsensystem auf den Abstandshaltern angeordnet. Als Materialien der Bodenplatte, der Abstandshalter und des Linsensystems sind Glas und Silizium angegeben. Für eine Bodenplatte und ein Linsensystem aus Glas wird die Verwendung von Abstandshaltern aus Silizium empfohlen, damit die Verbindung durch anodisches Bonden hergestellt werden kann.

Es ist eine Aufgabe der Erfindung, ein optoelektronisches Halbleitermodul anzugeben, das besonders gute optische Eigenschaften aufweist.

Diese Aufgabe wird durch ein optoelektronisches Halbleitermodul und ein Verfahren zum Herstellen eines optoelektronischen Halbleitermoduls gemäß den nebengeordneten Ansprüchen gelöst. Vorteilhafte Ausgestaltungen und Weiterbildungen des Halbleitermoduls und des Verfahrens sind in den abhängigen Ansprüchen angegeben. Der Offenbarungsgehalt der Patentansprüche wird hiermit explizit durch Rückbezug in die Beschreibung mit aufgenommen.

Ein optoelektronisches Halbleitermodul gemäß der Erfindung weist einen Chipträger auf, auf dem ein lichtemittierender Halbleiterchip montiert ist.

Der Chipträger enthält beispielsweise ein keramisches Material, zum Beispiel Aluminiumnitrid. Bei einer Ausgestaltung weist der Chipträger eine Leiterbahnstruktur zur elektrischen Kontaktierung des lichtemittierenden Halbleiterchips auf. Bei einer Weiterbildung hat der Chipträger eine Mehrlagenstruktur und weist eine Leiterbahnstruktur auf, die stellenweise im Inneren des Chipträgers verläuft. Beispielsweise ist der Chipträger eine Metallkernplatine. So wird insbesondere eine Leiterbahnstruktur erzielt, die zwei Leiterbahnen aufweist, die sich in Draufsicht auf die Haupterstreckungsebene des Chipträgers überschneiden und/oder kreuzen und die elektrisch voneinander isoliert sind.

Bei dem lichtemittierenden Halbleiterchip handelt es sich vorzugsweise um eine Leuchtdiode (LED, light emitting diode). Alternativ kann es sich um eine organische Leuchtdiode (OLED, organic light emitting diode) oder eine Laserdiode handeln.

Das optoelektronische Halbleitermodul ist im Folgenden in Verbindung mit einem lichtemittierenden Halbleiterchip beschrieben. Alternativ kann jedoch statt einem lichtemittierenden auch ein lichtempfangender Halbleiterchip wie eine Fotodiode oder ein lichtemittierender und -empfangender Halbleiterchip verwendet sein.

Unter "lichtemittierend" bzw. "lichtempfangend" wird im vorliegenden Zusammenhang verstanden, dass der Halbleiterchip elektromagnetische Strahlung im infraroten, sichtbaren und/oder ultravioletten Spektralbereich aussendet und/oder detektiert.

Der lichtemittierende Halbleiterchip weist insbesondere eine aktive Halbleiterschichtenfolge auf, die einen pn-Übergang, eine Doppelheterostruktur, einen Einfach-Quantentopf oder eine Mehrfach-Quantentopfstruktur (MQW) zur Lichterzeugung und/oder zum Lichtempfang umfasst.

Die Bezeichnung Quantentopfstruktur entfaltet hierbei keine Bedeutung hinsichtlich der Dimensionalität der Quantisierung. Sie umfasst somit u. a. Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben.

Bei einer Ausgestaltung ist der Halbleiterchip ein Dünnfilm-Halbleiterchip.

Ein Dünnfilm-Halbleiterchip zeichnet sich insbesondere durch mindestens eines der folgenden charakteristischen Merkmale aus:
- an einer zu einem Epitaxieträgerelement hin gewandten ersten Hauptfläche einer epitaktischen aktiven Halbleiterschichtenfolge ist eine reflektierende Schicht aufgebracht oder ausgebildet, die zumindest einen Teil des in der aktiven Halbleiterschichtenfolge erzeugten Lichts in diese zurückreflektiert;
- der Dünnfilm-Halbleiterchip umfasst ein Epitaxieträgerelement, bei dem es sich nicht um das Wachstumssubstrat handelt, auf dem die aktive Halbleiterschichtenfolge epitaktisch gewachsen wurde, sondern um ein separates Epitaxieträgerelement, das nachträglich an der epitaktischen aktiven Halbleiterschichtenfolge befestigt wurde,
- das Wachstumssubstrat der epitaktischen aktiven Halbleiterschichtenfolge ist von der epitaktischen aktiven Halbleiterschichtenfolge entfernt oder derart gedünnt, dass es zusammen mit der epitaktischen aktiven Halbleiterschichtenfolge alleine nicht frei tragend ist, oder
- die epitaktische aktive Halbleiterschichtenfolge weist eine Dicke im Bereich von 20*µ*m oder weniger, insbesondere im Bereich von 10 *µ*m oder weniger auf.

Das Epitaxieträgerelement ist bevorzugt durchlässig für eine von dem Halbleiterchip emittierte Strahlung ausgebildet. Weiterhin enthält die epitaktische aktive Halbleiterschichtenfolge bevorzugt mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf. Ein Grundprinzip eines Dünnfilm-Leuchtdiodenchips ist beispielsweise in I. Schnitzer et al., Appl. Phys. Lett. 63 (16), 18. Oktober 1993, S. 2174-2176 beschrieben. Beispiele für Dünnfilm-Leuchtdioden-Chips sind in den Druckschriften EP 0905797 A2 und WO 02/13281 A1 beschrieben.

Ein Dünnfilm-Leuchtdioden-Chip ist in guter Näherung ein Lambert'scher Oberflächenstrahler und eignet sich von daher besonders gut für die Anwendung in einem Scheinwerfer.

Bei einer Ausgestaltung weist der Halbleiterchip eine Lumineszenzkonversionsschicht auf, die auf die aktive Halbleiterschichtenfolge aufgebracht ist.

Die Lumineszenzkonversionsschicht weist mindestens einen Leuchtstoff, insbesondere einen anorganischen Leuchtstoff auf. Bei dem Leuchtstoff handelt es sich zum Beispiel um Yttrium-Aluminium-Granat, das mit einem Selten-Erd-Material wie Cer dotiert ist. Auch andere Granat-Leuchtstoffe und weitere Leuchstoffe wie Aluminate und/oder Orthosilikate sind denkbar.

Die Lumineszenzkonversionsschicht konvertiert die Wellenlänge von der aktiven Halbleiterschichtenfolge in einem ersten Spektralbereich emittierten Lichts in einen zweiten, von dem ersten verschiedenen Spektralbereich. Bei einer Ausgestaltung sendet der Halbleiterchip Mischlicht aus, das unkonvertiertes Licht des ersten Spektralbereichs (Primärstrahlung) und konvertiertes Licht des zweiten Spektralbereichs (Sekundärstrahlung) enthält. Beispielsweise erzeugt das von dem Halbleiterchip mit Lumineszenzkonversionsschicht ausgesandte Licht einen weißen Farbeindruck.

Weiter wird ein Abdeckelement für ein optoelektronisches Halbleiterbauelement angegeben. Das optoelektronische Halbleitermodul weist ein solches Abdeckelement auf. Das Abdeckelement weist eine Abdeckplatte und ein Rahmenteil auf. Die Abdeckplatte ist zumindest teilweise für das von dem Halbleiterchip emittierte und/oder empfangene Licht durchlässig. Bei einer Ausgestaltung ist die Abdeckplatte transparent. Das Rahmenteil ist bei einer Ausgestaltung lichtundurchlässig oder zumindest für von dem Halbleiterchip emittiertes Licht undurchlässig.

Das Abdeckelement, insbesondere die Abdeckplatte, weist bei einer Ausgestaltung ein keramisches Material und/oder ein Glasmaterial auf. Das Rahmenteil weist bei einer Ausgestaltung ein Halbleitermaterial auf.

Mit Vorteil sind keramische Materialien, Glasmaterialien und/oder Halbleitermaterialien sind besonders gut für Scheinwerferanwendungen geeignet, bei denen beispielsweise oft hohe Betriebstemperaturen und, insbesondere bei Scheinwerfern für Kraftfahrzeuge, große und/oder häufige Temperaturschwankungen auftreten. Insbesondere hat das optoelektronische Halbleitermodul eine hohe Lebensdauer.

Vorteilhafterweise haben Abdeckelemente mit keramischen Materialien, Glasmaterialien und/oder Halbleitermaterialien gute optische Eigenschaften, insbesondere wird eine präzise Strahlformung erzielt. Das optoelektronische Halbleitermodul ist daher beispielsweise besonders gut zur Verwendung in einer Projektionsvorrichtung geeignet, insbesondere zur Darstellung einer Information, die beispielsweise eine Mehrzahl von Bildpunkten aufweist.

Mittels des Abdeckelements wird die Gefahr einer Verschmutzung und/oder einer mechanischen Beschädigung des Halbleiterchips und gegebenenfalls eines Bonddrahts, mit dem der Halbleiterchip elektrisch mit dem Chipträger kontaktiert ist, verringert.

Auf eine Einbettung des Halbleiterchips in eine Vergussmasse kann mit Vorteil verzichtet werden. Stattdessen erfolgt die Auskopplung und/oder Einkopplung des von dem Halbleiterchip emittierten und/oder empfangenen Lichts gegen Luft.

Mit anderen Worten ist vorzugsweise ein von dem Abdeckelement und dem Chipträger umschlossener Bereich, der den Halbleiterchip enthält, frei von einer den Halbleiterchip verkapselnden Vergussmasse.

Mit Vorteil ist die Effizienz der Auskopplung auf diese Weise bei einem lichtemittierenden Dünnfilm-Halbleiterchip zum Beispiel um etwa 15 % und bei einem Halbleiterchip mit einer Lumineszenzkonversionsschicht beispielsweise um etwa 25% gegenüber einer Auskopplung in eine Vergussmasse erhöht.

Die Abdeckplatte des Abdeckelements ist auf der von dem Chipträger abgewandten Seite des Halbleiterchips angeordnet. Das Rahmenteil des Abdeckelements umgibt den Halbleiterchip seitlich.

Bei einer Ausführungsform umschließt das Rahmenteil den Halbleiterchip in Draufsicht auf den Chipträger vollständig. Bei einer Weiterbildung dieser Ausgestaltung umschließen das Abdeckelement und der Chipträger einen Innenraum, der den Halbleiterchip enthält, vollständig. Mit Vorteil ist der Halbleiterchip so beispielsweise gegen Staub und/oder Feuchtigkeit geschützt.

Bei einer alternativen Ausführungsform enthält das Rahmenteil zumindest einen Durchbruch. Bei dieser Ausführungsform ist der Halbleiterchip in Draufsicht auf den Chipträger seitlich nicht vollständig umschlossen. Beispielsweise besteht das Rahmenteil aus einer Mehrzahl von einzelnen, voneinander beabstandeten Teilstücken wie Stegen und/oder Pfosten.

Auf diese Weise wird eine gute Dissipation von Verlustwärme, welche im Betrieb des Halbleiterchips erzeugt wird, erzielt. Diese Ausführungsform ist auch vorteilhaft, wenn das Abdeckelement, der Chipträger und/oder gegebenenfalls eine Befestigungsschicht, mittels welcher das Abdeckelement mit dem Chipträger verbunden ist, einen insbesondere gasförmigen Stoff absondert, bei dem die Gefahr besteht, dass er sich in einem vollständig abgeschlossenen Innenraum anreichert und die Effizienz und/oder die Lebensdauer des Halbleitermoduls beeinträchtigt.

Das Rahmenteil ist fügeschichtlos mit der Abdeckplatte verbunden und vorzugsweise an seiner von der Abdeckplatte entfernten Seite mit dem Chipträger verbunden, insbesondere mechanisch stabil befestigt.

Unter einer fügeschichtlosen Verbindung zwischen der Abdeckplatte und dem Rahmenteil wird im vorliegenden Zusammenhang eine mechanisch stabile Verbindung verstanden, die nicht mittels einer separaten, auf das Rahmenteil und/oder die Abdeckplatte aufgebrachten Haftvermittlungsschicht - wie etwa einer Klebstoffschicht - hergestellt ist. Mit anderen Worten ist die Verbindung klebstofffrei hergestellt. Bevorzugt weist das Abdeckelement keine zwischen dem Rahmenteil und der Abdeckplatte angeordnete Verbindungsschicht auf. Vielmehr grenzen die Abdeckplatte und das Rahmenteil insbesondere direkt aneinander an. Es handelt sich, anders ausgedrückt, vorzugsweise um eine stoffschlüssige Verbindung zwischen der Abdeckplatte und dem Rahmenteil. Insbesondere ist die Verbindung unlösbar, also nur durch Zerstörung der Abdeckplatte und/oder des Rahmenteils lösbar.

Fügeschichten und/oder überschüssiges Fügeschichtmaterial, etwa Klebstoffkehlen, sind oft Quellen für unerwünschtes Streulicht und/oder für unerwünschte Reflexionen. Mit der fügeschichtlosen Verbindung von Abdeckplatte und Rahmenteil wird vorteilhafterweise die Gefahr verringert, dass das Abdeckelement unerwünschtes Streulicht und/oder unerwünschte Reflexionen verursacht. Das optoelektronische Halbleitermodul weist so besonders gute optische Eigenschaften, insbesondere einen hohen Kontrast und/oder eine scharfe Begrenzung der leuchtenden Fläche, auf.

Bei einer Ausgestaltung sendet das optoelektronische Halbleitermodul im Betrieb Lichtstrahlen aus, die mit der Haupterstreckungsebene des Chipträgers einen Winkel von kleiner oder gleich 10°, bevorzugt von kleiner oder gleich 8°, besonders bevorzugt von kleiner oder gleich 6° einschließen. Derart flache Abstrahlwinkel werden vorteilhafterweise aufgrund der vermittels der fügeschichtlosen Verbindung zwischen Abdeckplatte und Rahmenteil besonders geringen Toleranzen des Abdeckelements erzielt. Auf diese Weise beleuchtet das Halbleitermodul beispielsweise mit Vorteil einen besonders großen Raumwinkelbereich.

Bei einer Ausgestaltung weist das Rahmenteil mindestens eine dem Halbleiterchip zugewandte schräge Seitenfläche auf. Anders ausgedrückt verläuft mindestens eine Innenfläche des Rahmenteils in einem Winkel zur Haupterstreckungsebene des Rahmenteils, der von einem rechten Winkel abweicht. Die Haupterstreckungsebene des Rahmenteils ist insbesondere parallel zur Haupterstreckungsebene der Abdeckplatte.

Handelt es sich bei der Seitenfläche nicht um eine ebene Fläche, sondern beispielsweise um eine Rotationsfläche, so ist unter dem Winkel zwischen der schrägen Seitenfläche und der Haupterstreckungsebene derjenige Winkel zu verstehen, den die schräge Seitenfläche und die Haupterstreckungsebene in einer Schnittebene miteinander einschließen, welche auch das Lot auf die Haupterstreckungsebene des Rahmenteils enthält.

Bei einer Ausführungsform schließt die schräge Seitenfläche mit der Haupterstreckungsebene des Rahmenteils einen Winkel von zwischen 40° und 70°, beispielsweise zwischen 50° und 60°, bevorzugt zwischen 53° und 56°, besonders bevorzugt von etwa 54,7° ein. Die Grenzen der Winkelbereich sind hierbei jeweils eingeschlossen. Der Winkel weicht insbesondere um 0,5° oder weniger von 54,7° ab. Bei einer anderen Ausführungsform ist der Winkel größer oder gleich 80°.

Alternativ oder zusätzlich zu einer schrägen Seitenfläche kann der Rahmen auch eine dem Halbleiterchip zugewandte, gekrümmt verlaufende Seitenfläche aufweisen.

Bei einer anderen Ausführungsform verkleinert sich ein lateraler Abstand zwischen der schrägen oder gekrümmten Seitenfläche und dem Halbleiterchip im Verlauf von dem Chipträger zur Abdeckplatte hin. Anders ausgedrückt verringert sich ein lateraler Abstand zwischen einer Außenkante der Abdeckplatte und der schrägen Innenfläche des Rahmenteils im Verlauf von der Abdeckplatte weg.

Mit Vorteil schattet die schräge oder gekrümmte Seitenfläche bei dieser Ausführungsform einen definierten Teil des von dem lichtemittierenden Halbleiterchip im Betrieb emittierten Lichts ab. Die der Abdeckplatte benachbarte - und insbesondere an diese angrenzende - Kante der schrägen oder gekrümmten Seitenfläche stellt mit Vorteil eine scharfe Grenze für den abgeschatteten Teil, eine sogenannte "Shutterkante" dar. Dies ist insbesondere für die Verwendung des Halbleitermoduls in einem Scheinwerfer, beispielsweise in einem Kraftfahrzeugscheinwerfer, von Vorteil.

Von dem Halbleiterchip emittiertes Licht, das auf die schräge Innenfläche auftrifft, wird bei dieser Ausführungsform vorteilhafterweise nicht oder nur zu einem geringen Teil direkt durch die Abdeckplatte hindurch aus dem Halbleitermodul ausgekoppelt. Dies ist insbesondere von Vorteil, wenn das Halbleitermodul in einem Scheinwerfer verwendet ist. Beispielsweise wird auf diese Weise eine hohe Homogenität der Leuchtdichte über die lichtemittierende Fläche des Halbleitermoduls erzielt.

Bei einer senkrecht auf der Haupterstreckungsebene des Rahmenteils stehenden Seitenfläche oder einer Seitenfläche, deren lateraler Abstand zum Halbleiterchip sich im Verlauf von dem Chipträger zur Abdeckplatte hin vergrößert, besteht dagegen eine größere Gefahr, dass das Rahmenteil im Betrieb des Halbleitermoduls mitleuchtet. Dies ist bei Scheinwerferanwendungen oft nicht erwünscht.

Bei einer alternativen Ausführungsform vergrößert sich ein lateraler Abstand zwischen der schrägen oder gekrümmten Seitenfläche und dem Halbleiterchip im Verlauf von dem Chipträger zur Abdeckplatte hin.

Auf diese Weise wird mit Vorteil ein besonders hoher Anteil des unter flachen Winkeln aus dem Halbleiterchip emittierten Lichts in Richtung der Abdeckplatte umgelenkt und aus dem Halbleitermodul ausgekoppelt. Das optoelektronische Halbleitermodul ist in dieser Ausführungsform besonders gut für die Allgemeinbeleuchtung, beispielsweise für die Verwendung in Leuchten, insbesondere zur Beleuchtung von Innenräumen wie Büroräumen oder Flugzeugkabinen geeignet.

Bei einer vorteilhaften Ausgestaltung sind die thermischen Wärmeausdehnungskoeffizienten der Abdeckplatte und des Rahmenteils und/oder die Wärmeausdehnungskoeffizienten des Rahmenteils und des Chipträgers aufeinander abgestimmt. Insbesondere unterscheiden sich die Wärmeausdehnungskoeffizienten der Abdeckplatte, des Rahmenteils und des Chipträgers um 2 x 10⁻⁶ 1/°C oder weniger, vorzugsweise um 1,5 x 10⁻⁶ 1/°C oder weniger. Der Wärmeausdehnungskoeffizient gibt dabei an, um welchen Betrag im Verhältnis zur gesamten Länge, sich ein fester Körper bei einer Temperaturänderung von einem Grad Kelvin beziehungsweise einem Grad Celsius vergrößert oder verkleinert. Vorteilhafterweise verringern aufeinander abgestimmte Wärmeausdehnungskoeffizienten mechanische Belastungen bei Temperaturschwankungen, so dass das Abdeckelement und das optoelektronische Halbleitermodul auch bei häufigen Temperaturwechseln eine hohe Lebensdauer aufweisen. Dies ist beispielsweise für die Verwendung bei der Kraftfahrzeugbeleuchtung besonders vorteilhaft.

Bei einer Ausgestaltung des optoelektronischen Halbleitermoduls ist die Abdeckplatte mit einer Antireflex-Schicht versehen. Die Antireflex-Schicht verringert insbesondere den Reflexionskoeffizienten der Abdeckplatte für von dem Halbleiterchip emittiertes Licht. Die Abdeckplatte ist auf der dem Halbleiterchip zugewandten und/oder auf der vom Halbleiterchip abgewandten Seite mit der Antireflex-Schicht versehen.

Bei einer weiteren Ausgestaltung ist das Rahmenteil an einer von der Abdeckplatte abgewandten und insbesondere dem Chipträger zugewandten Seite mit einer elektrischen Isolationsschicht versehen. Beispielsweise bei einem elektrisch leitfähigen Rahmenteil isoliert die elektrische Isolationsschicht das Rahmenteil mit Vorteil elektrisch von mindestens einer Leiterbahn der Leiterbahnstruktur des Chipträgers.

Alternativ oder zusätzlich zu einer schrägen Seitenwand des Rahmenteils einen definierten Teil des von dem lichtemittierenden Halbleiterchip im Betrieb emittierten Lichts abschattet, ist bei einer anderen Ausgestaltung die Abdeckplatte stellenweise mit einer reflektierenden und/oder absorbierenden Schicht versehen. Die reflektierende und/oder absorbierende Schicht reflektiert bzw. absorbiert von dem Halbleiterchip emittiertes Licht und schattet so vorteilhafterweise einen weiteren definierten Teil des von dem lichtemittierenden Halbleiterchip im Betrieb emittierten Lichts ab. Insbesondere transmittiert die reflektierende und/oder absorbierende Schicht weniger als 15 %, bevorzugt weniger als 5 %, besonders bevorzugt weniger als 2 % des Lichts, mit welchem sie von dem Halbleiterchip beleuchtet wird.

Beispielsweise wird mittels der reflektierenden und/oder absorbierenden Schicht eine asymmetrische Geometrie des Lichtauskoppelbereichs der Abdeckplatte erzielt, also desjenigen Bereichs der Abdeckplatte, durch den hindurch Licht aus dem Halbleitermodul ausgekoppelt wird. Ein asymmetrischer Lichtauskoppelbereich ist beispielsweise bei der Verwendung des optoelektronischen Halbleitermoduls für einen Abblendlicht-Scheinwerfer eines Kraftfahrzeugs vorteilhaft. Die reflektierende und/oder absorbierende Schicht enthält beispielsweise ein Tantalnitrid wie TaN, Silizium und/oder Chrom oder besteht aus einem dieser Materialien.

Bei einer anderen Ausgestaltung weist die Abdeckplatte ein Strahlformungselement auf. Das Strahlformungselement ist vorzugsweise mit der Abdeckplatte integriert ausgebildet, insbesondere weist die Abdeckplatte einen Vorsprung und/oder eine Vertiefung auf. Beispielsweise enthält die Abdeckplatte ein Linsenelement und/oder ein Prismenelement, an welchem durch die Abdeckplatte tretendes Licht gebrochen und/oder reflektiert wird.

Bei einer weiteren Ausgestaltung ist die Abdeckplatte mit einem Leuchtstoff versehen. Als Leuchtstoffe sind beispielsweise die in Zusammenhang mit der Lumineszenzkonversionsschicht des Halbleiterchips beschriebenen Leuchtstoffe geeignet. Der Leuchtstoff kann auf die Abdeckplatte aufgebracht sein, zum Beispiel mittels eines Aufdampf- oder eines Pulverbeschichtungsverfahrens. Alternativ oder zusätzlich kann der Leuchtstoff oder ein weiterer Leuchtstoff in der Abdeckplatte enthalten sein. Zum Beispiel ist der Leuchtstoff oder der weitere Leuchtstoff in die Abdeckplatte eingeschmolzen.

Bei einer weiteren Ausgestaltung ist das Rahmenteil an den Chipträger gelötet. Insbesondere bei einem Rahmenteil, das in Draufsicht auf seine Haupterstreckungsebene den Halbleiterchip vollständig umschließt, wird so eine besonders gute Dichtigkeit des von dem Abdeckelement und dem Chipträger umschlossenen Innenraums erzielt.

Bei einer Ausgestaltung enthält das Rahmenteil Silizium. Bei einer weiteren Ausgestaltung enthält die Abdeckplatte Borsilikatglas, bei dem es sich insbesondere um ein Floatglas handelt. Beispielsweise weist das Borsilikatglas etwa 80 - 81 % SiO₂, etwa 13 % B₂O₃, etwa 2 - 2,5 % Al₂O₃ und etwa 4 % Na₂O und/oder K₂O auf. Derartiges Borsilikatglas ist beispielsweise unter den Markennamen "Pyrex" oder "Borofloat 33" (BF33) erhältlich.

Bei einer vorteilhaften Weiterbildung weist die Abdeckplatte Borsilikatglas und das Rahmenteil Silizium auf. Mit Vorteil weichen die Wärmeausdehnungskoeffizienten von Borsilikatglas und Silizium nur geringfügig voneinander ab, sie sind also aufeinander abgestimmt. Bei einer weiteren Ausgestaltung enthält der Chipträger Aluminiumnitrid. Vorteilhafterweise ist der Wärmeausdehnungskoeffizient von Aluminiumnitrid sowohl auf den Wärmeausdehnungskoeffizienten von Borsilikatglas als auch auf den Wärmeausdehnungskoeffizienden von Silizium abgestimmt. Vorteilhafterweise unterscheiden sich die Werte der Wärmeausdehnungskoeffizienten von Borsilikatglas, Silizium und Aluminiumnitrid um 2 x 10⁻⁶ 1/°C oder weniger, insbesondere um 1,5 x 10⁻⁶ 1/°C oder weniger.

Das optoelektronische Halbleitermodul ist zum Beispiel in einem Scheinwerfer, insbesondere einem Kraftfahrzeugscheinwerfer enthalten. Bei einer alternativen Ausführungsform ist das optoelektronische Halbleitermodul in einer Projektionsvorrichtung enthalten. Bei einer wiederum anderen Ausführungsform ist es in einer Leuchte enthalten, die insbesondere zur Allgemeinbeleuchtung, etwa zur Beleuchtung eines Innenraums wie eines Büroraums oder einer Flugzeugkabine, vorgesehen ist.

Ein Verfahren zum Herstellen eines Abdeckelements für ein optoelektronisches Halbleitermodul umfasst die Schritte:
- Bereitstellen eines lichtdurchlässigen Abdeckplattenwafers und eines Rahmenwafers;
- Herstellen einer Öffnung in dem Rahmenwafer;
- Fügeschichtloses Befestigen des Rahmenwafers an dem Abdeckplattenwafer;
- Abtrennen eines Abdeckelements aus dem Verbund von Rahmenwafer und Abdeckplattenwafer, wobei ein abgetrenntes Teilstück des Abdeckplattenwafers eine Abdeckplatte des Abdeckelements bildet, und ein abgetrenntes Teilstück des Rahmenwafers, das die Öffnung zumindest teilweise enthält, ein mit der Abdeckplatte verbundenes Rahmenteil des Abdeckelements bildet.

Die Öffnung hat beispielsweise eine kreisförmige, ellipsenförmige, rechteckige oder quadratische Querschnittsfläche und ist vollständig in dem Teilstück des Rahmenwafers enthalten, welches das Rahmenteil bildet.

Bei einer anderen Ausgestaltung hat die Öffnung einen streifenförmigen Querschnitt. Bei einem streifenförmigen Querschnitt hat die Länge vorzugsweise einen um einen Faktor größer oder gleich 2, besonders bevorzugt um einen Faktor größer oder gleich 5 höheren Wert als die Breite. Insbesondere enthält das Teilstück des Rahmenwafers, welches das Rahmenteil bildet, nur einen Teilbereich der Öffnung. Anders ausgedrückt wird bei dieser Ausgestaltung ein Abdeckelement abgetrennt, dessen Rahmenteil zwei voneinander beabstandete, disjunkte Teilstücke wie Stege aufweist. Zum Beispiel hat mindestens eines der Teilstücke mit der Abdeckplatte eine gemeinsame Kante.

Mittels der fügeschichtlosen Verbindung des Rahmenwafers und des Abdeckplattenwafers wird vorteilhafterweise eine besonders genaue Positionierung der Abdeckplatte und des Rahmenteils erzielt. Mit Vorteil wird auf diese Weise ein Abdeckelement hergestellt, das besonders geringe Fertigungstoleranzen aufweist. Auf diese Weise wird beispielsweise ein Abdeckelement mit besonders geringen Abmessungen erzielt.

Vorzugsweise wird bei dem Verfahren eine Mehrzahl von Öffnungen in dem Rahmenwafer hergestellt und der Verbund von Rahmenwafer und Abdeckplattenwafer mittels Schnitten durch den Verbund zu einer Mehrzahl von Abdeckelementen vereinzelt.

Das Abtrennen des Abdeckelements aus dem Verbund von Rahmenwafer und Abdeckplattenwafer erfolgt bevorzugt mittels Schnitten durch den Verbund, wobei die Schnitte das Teilstück des Abdeckplattenwafers abtrennen, das die Abdeckplatte des Abdeckelements bildet, und das Teilstück des Rahmenwafers abtrennen, das die Öffnung zumindest teilweise enthält und ein mit der Abdeckplatte verbundenes Rahmenteil bildet. Die Schnitte werden vorzugsweise mittels eines Sägeverfahrens, eines Lasertrennverfahrens oder eines nass- oder trockenchemischen Ätzverfahrens erzeugt.

Das Herstellen der fügeschichtlosen Verbindung des Rahmenwafers mit dem Abdeckplattenwafer umfasst bei einer Ausgestaltung einen anodischen Bondprozess. Bei dem anodischen Bondprozess werden der Rahmenwafer und der Abdeckplattenwafer in mechanischen Kontakt gebracht und es wird eine elektrische Spannung zwischen dem Rahmenwafer und dem Abdeckplattenwafer angelegt. Das Anlegen der elektrischen Spannung erfolgt vorzugsweise bei einer gegenüber Raumtemperatur erhöhten Temperatur. Zumindest die Fläche des Rahmenwafers die mit dem Abdeckplattenwafer in mechanischen Kontakt gebracht wird, und/oder die Fläche des Abdeckplattenwafers, die mit dem Rahmenwafer in mechanischen Kontakt gebracht wird, ist vorzugsweise poliert.

Bei einer Weiterbildung weist der Rahmenwafer Silizium auf oder besteht daraus. Insbesondere handelt es sich bei dem Rahmenwafer um einen einkristallinen Siliziumwafer in (100)-Orientierung, der vorzugsweise beidseitig poliert ist. Der Rahmenwafer hat zum Beispiel einen Durchmesser von 6 Zoll oder von 8 Zoll.

Der Abdeckplattenwafer weist beispielsweise ein keramisches Material und/oder ein Glasmaterial, insbesondere Borsilikatglas, auf oder besteht daraus. Vorzugsweise enthält das Glasmaterial Natriumoxid. Zwischen einem Abdeckplattenwafer, der Natriumoxid enthält und einem Rahmenwafer, der Silizium enthält, wird vorteilhafterweise bei dem anodischen Bondprozess eine besonders stabile mechanische Verbindung hergestellt.

Bei einer anderen Ausgestaltung umfasst das Herstellen der Öffnung ein nass- und/oder trockenchemisches Ätzverfahren, etwa mittels Kaliumhydroxid und/oder Tetramethylammoniumhydroxid, und/oder ein Sandstrahlverfahren, etwa mittels Aluminiumoxid-Pulver. Hierzu wird vorzugsweise eine strukturierte Maskenschicht auf den Rahmenwafer aufgebracht, welche die Öffnung definiert, und durch welche hindurch das Ätzen und/oder Sandstrahlen erfolgt. Für die strukturierte Maskenschicht geeignete Materialien sind beispielsweise Lacke, Metalle, Nitride wie Siliziumnitrid und/oder Oxide wie Siliziumoxid. Nitride und Oxide sind insbesondere für Ätzverfahren geeignet. Bei dem Ätzverfahren beziehungsweise dem Sandstrahlverfahren handelt es sich insbesondere um einen anisotropen Prozess.

Die strukturierte Maskenschicht kann nach dem Herstellen der Öffnung entfernt werden. Alternativ kann sie auch auf dem Rahmenwafer verbleiben. Beispielsweise stellt der in dem Abdeckelement enthaltene Teilbereich der Maskenschicht die Isolationsschicht dar.

Vorzugsweise wird bei dem Verfahren die Öffnung, insbesondere mittels des anisotropen Ätz- und/oder Sandstrahlverfahrens, so hergestellt, dass sie schräge Seitenflächen oder mindestens eine schräge Seitenfläche aufweist. Die schräge(n) Seitenfläche(n) schließen zum Beispiel mit der Haupterstreckungsebene des Rahmenwafers einen Winkel ein, der um 0,5° oder weniger von 54,7° abweicht.

Bei einer anderen Ausgestaltung des Verfahrens wird eine Antireflex-Schicht auf den Abdeckplattenwafer aufgebracht.

Bei einer Ausführungsform wird die Antireflex-Schicht nach dem Verbinden von Rahmenwafer und Abdeckplattenwafer auf die von dem Rahmenwafer abgewandte Seite des Abdeckplattenwafers aufgebracht. Zusätzlich oder alternativ kann sie auch auf die dem Rahmenwafer zugewandte Seite des Abdeckplattenwafers aufgebracht werden. In diesem Fall wird bei einer Ausgestaltung auch der Rahmenwafer mit der Antireflex-Schicht beschichtet.

Bei einer alternativen Ausführungsform werden eine oder beide Hauptflächen des Abdeckplattenwafers vor dem Verbinden von Abdeckplattenwafer und Rahmenwafer mit der Antireflex-Schicht versehen. Wird die Antireflex-Schicht auf die erste Hauptfläche des Abdeckplattenwafers aufgebracht, die bei einem nachfolgenden Verfahrensschritt mit dem Rahmenwafer verbunden wird, wird sie vorzugsweise zumindest auf dieser Hauptfläche strukturiert aufgebracht. Besonders bevorzugt wird das Verfahren so durchgeführt, dass diejenigen Stellen der ersten Hauptfläche, die in mechanischen Kontakt mit Rahmenwafer gebracht werden, von der Antireflex-Schicht unbedeckt sind. Anders ausgedrückt ist die Antireflex-Schicht auf dem Bereich der ersten Hauptfläche aufgebracht, die in der Verbindungsebene von Abdeckplattenwafer und Rahmenwafer mit der Öffnung des Rahmenwafers überlappt. Diese Ausführungsform ist insbesondere für eine Ausgestaltung des Abdeckelements vorteilhaft, bei der sich die Öffnung im Verlauf von der Abdeckplatte weg verjüngt.

Das strukturierte Aufbringen umfasst dabei zum Beispiel einen fotolithografischen Prozess, etwa unter Verwendung eines Negativ-Fotolacks. Beispielsweise wird die Hauptfläche zunächst mit einer strukturierten Fotolackschicht versehen, anschließend die Antireflex-Schicht auf den Abdeckplattenwafer und die Fotolackschicht aufgebracht und nachfolgend die Fotolackschicht mit dem darauf aufgebrachten Teil der Antireflex-Schicht wieder entfernt.

Bei einer anderen Ausgestaltung des Verfahrens wird das Teilstück des Abdeckplattenwafers, welches die Abdeckplatte bildet, vor oder nach dem Abtrennen des Abdeckelements stellenweise mit einer reflektierenden und/oder absorbierenden Schicht versehen.

Bei einer weiteren Ausgestaltung weist das Teilstück des Abdeckplattenwafers, welches die Abdeckplatte bildet, ein Strahlformungselement auf.

Ein Verfahren zum Herstellen eines optoelektronischen Halbleitermoduls umfasst zusätzlich die Schritte:
- Montieren eines lichtemittierenden und/oder -empfangenden Halbleiterchips auf einem Chipträger;
- Befestigen des Rahmenteils an dem Chipträger, derart, dass das Rahmenteil den Halbleiterchip lateral umgibt und er Halbleiterchip zwischen der Abdeckplatte und dem Chipträger angeordnet ist.

Weitere Vorteile und vorteilhafte Ausgestaltungen und Weiterbildungen des Abdeckelements, des optoelektronischen Halbleitermoduls und des Verfahrens ergeben sich aus den folgenden, in Zusammenhang mit den Figuren 1 bis 19 dargestellten Ausführungsbeispielen.

Es zeigen:
- Figuren 1-5,: schematische Querschnitte von verschiedenen Stadien eines Verfahrens zum Herstellen eines Abdeckelements für ein optoelektronisches Halbleitermodul gemäß einem ersten Ausführungsbeispiel,
- Figur 6,: einen schematischen Querschnitt durch eine Variante des Abdeckelements gemäß dem ersten Ausführungsbeispiel bei dem Verfahrensstadium der Figur 3,
- Figuren 7A-7C,: schematische Draufsichten auf verschiedene Varianten von Abdeckelementen,
- Figuren 8-12,: schematische Querschnitte von verschiedenen Stadien eines Verfahrens zum Herstellen eines Abdeckelements für ein optoelektronisches Halbleitermodul gemäß einem zweiten Ausführungsbeispiel,
- Figur 13,: schematischer Querschnitt durch ein Abdeckelement bei einem Verfahren zum Herstellen eines optoelektronischen Halbleitermoduls,
- Figur 14,: schematischer Querschnitt durch ein optoelektronisches Halbleitermodul gemäß einem dritten Ausführungsbeispiel,
- Figur 15,: schematische Draufsicht auf das optoelektronische Halbleitermodul der Figur 14,
- Figur 16A,: schematischer Querschnitt durch ein optoelektronisches Halbleitermodul gemäß einer Variante des dritten Ausführungsbeispiels,
- Figur 16B,: schematische Draufsicht auf das Abdeckelement der Figur 16A,
- Figur 17,: schematischer Querschnitt durch ein optoelektronisches Halbleitermodul gemäß einem vierten Ausführungsbeispiel,
- Figur 18,: schematischer Querschnitt durch ein optoelektronisches Halbleitermodul gemäß einem fünften Ausführungsbeispiel, und
- Figur 19,: Diagramm mit Wärmeausdehnungskoeffizienten verschiedener Materialien.

In den Ausführungsbeispielen und Figuren sind gleiche oder gleich wirkende Bestandteile mit gleichen Bezugszeichen versehen. Die Figuren und die Größenverhältnisse der in den Figuren dargestellten Elemente sind grundsätzlich nicht als maßstäblich zu betrachten. Vielmehr können einzelne Elemente, wie zum Beispiel Schichten, zur besseren Darstellbarkeit und/oder zum besseren Verständnis übertrieben groß oder dick dargestellt sein.

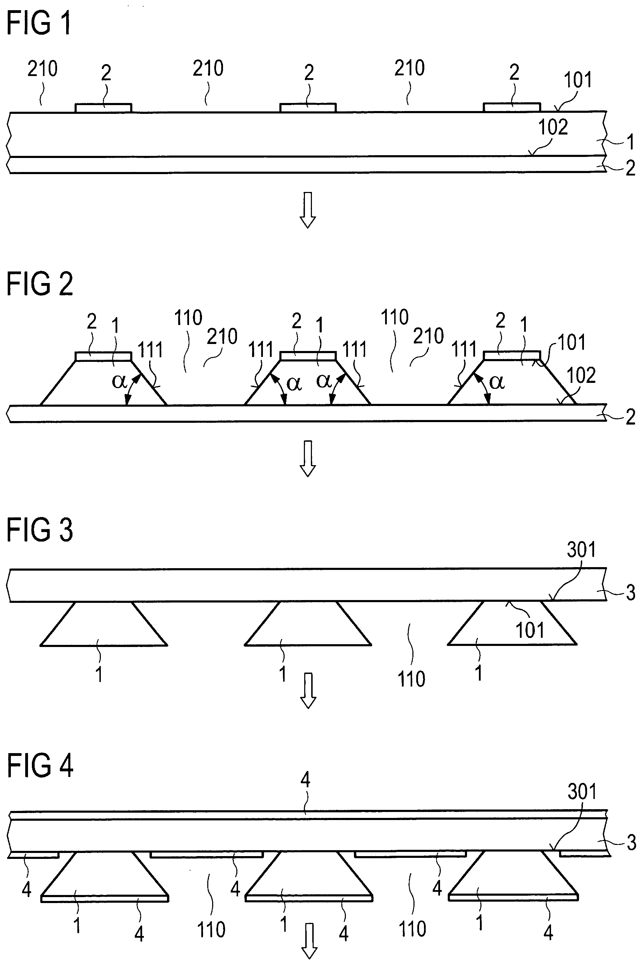

In den Figuren 1 bis 5 sind verschiedene Stadien eines ersten Ausführungsbeispiels eines Verfahrens zur Herstellung eines Abdeckelements für ein optoelektronisches Halbleitermodul in schematischen Querschnitten dargestellt.

Figur 1 zeigt einen ersten Verfahrensschritt des Verfahrens. Es wird ein lichtundurchlässiger Rahmenwafer 1 bereitgestellt, der mit einer Maskenschicht 2 aus Siliziumoxid- oder Siliziumnitrid beschichtet wird. Bei dem Rahmenwafer handelt es sich bei dem vorliegenden Ausführungsbeispiel um einen beidseitig polierten Si-Wafer in (100)-Orientierung mit einem Durchmesser von 6 Zoll oder 8 Zoll.

Auf einer ersten Hauptfläche 101 des Rahmenwafers 1 wird die Maskenschicht 2 strukturiert aufgebracht, vorliegend weist sie Aussparungen 210 auf, die in Draufsicht die Form eines Rechtecks haben. Auf einer zweiten, der ersten gegenüberliegenden Hauptfläche 102 wird die Maskenschicht 2 vollflächig aufgebracht. Das Aufbringen der Maskenschicht 2 erfolgt beispielsweise mittels eines thermischen Oxidationsprozesses oder mittels eines, insbesondere plasmaunterstützten Verdampfungsprozesses wie physikalischer Gasphasenabscheidung (PVD, physical vapor deposition).

Wie in Figur 2 gezeigt, werden in dem Rahmenwafer 1 anschließend Öffnungen 110 hergestellt. Die Öffnungen werden durch Ätzen des Rahmenwafers 1 mit Kaliumhydroxid (KOH) oder Tetramethylammoniumhydroxid (TMAH) durch die Aussparungen 210 der Maskenschicht 2 hindurch erzeugt.

KOH beziehungsweise TMAH ätzen den Si-Wafer 1 in Bezug auf die <100> und <111> Ebene unterschiedlich stark. Die Seitenflächen 111 der Öffnungen 110 schließen mit der Haupterstreckungsebene des Rahmenwafers 1 bei diesem Ätzverfahren einen Winkel α von etwa 54,7° ein. Die Haupterstreckungsebene des Rahmenwafers 1 ist zumindest im Wesentlichen parallel zu den Hauptflächen seiner Oberfläche, also zur ersten und zweiten Hauptfläche 101, 102. Eine mögliche Abweichung des Winkels α von einem Wert von 54,7° beruht üblicherweise im Wesentlichen auf einer Verkippung der Hauptflächen 101, 102 des Rahmenwafers 1 zur <100> Ebene. Die Verkippung hat vorzugsweise einen Wert von 0,5° oder weniger, so dass der Winkel α bevorzugt um 0,5° oder weniger von 54,7° abweicht. Die Öffnungen 110 verjüngen sich in Richtung von der ersten Hauptfläche 101 zur zweiten Hauptfläche 102 des Rahmenwafers.

In einem nachfolgenden Verfahrensschritt (siehe Fig. 3) wird die Maskenschicht 2 von dem Rahmenwafer 1 entfernt, zum Beispiel mit Hilfe einer gepufferten Fluorwasserstoff-Lösung. Alternativ kann die strukturierte Maskenschicht 2 auch als Isolationsschicht auf der ersten Hauptfläche 101 des Rahmenwafers 1 verbleiben.

Mit der ersten Hauptfläche 101 des Rahmenwafers 1 wird anschließend eine erste Hauptfläche 301 eines Abdeckplattenwafers 3 mittels eines anodischen Bondprozesses verbunden. Der Abdeckplattenwafer 3 ist vorliegend transparent und besteht aus einem Borsilikat-Floatglas, insbesondere BF33, das Natriumoxid enthält.

Zum anodischen Bonden werden die erste Hauptfläche 101 des Rahmenwafers 1 und die erste Hauptfläche 301 des Abdeckplattenwafers 3 bei einer gegenüber Raumtemperatur erhöhten Temperatur von beispielsweise größer oder gleich 350 °C und/oder kleiner oder gleich 500 °C in mechanischen Kontakt gebracht. Die erste Hauptfläche 101 des Rahmenwafers 1 und die erste Hauptfläche 301 des Abdeckplattenwafers 3 grenzen direkt aneinander an. Sie sind insbesondere in einer gemeinsamen Verbindungsebene enthalten.

Anschließend wird eine elektrische Spannung zwischen dem Rahmenwafer 1 und dem Abdeckplattenwafer 3 angelegt. Die elektrische Spannung hat beispielsweise einen Wert von größer oder gleich 100 V und/oder von kleiner oder gleich 5 kV. Beispielsweise hat sie einen Wert zwischen 500 V und 2500 V, wobei die Grenzen eingeschlossen sind.

Bei dem anodischen Bondprozess werden beispielsweise NatriumIonen des in dem Abdeckplattenwafer 3 enthaltenen Natriumoxids frei und Sauerstoffionen des Natriumxids gehen eine Bindung mit Siliziumionen des Rahmenwafers 1 ein. Auf diese Weise wird eine mechanisch stabile und insbesondere unlösbare Verbindung zwischen dem Rahmenwafer 1 und dem Abdeckplattenwafer 3 hergestellt.

Nachfolgend wird der Abdeckplattenwafer 3 beidseitig mit einer Antireflex-Schicht 4 - etwa einer TaN-, Si- oder Cr-Schicht - beschichtet (siehe Fig. 4). Die Beschichtung der ersten Hauptfläche 301 des Abdeckplattenwafers 3 erfolgt dabei durch die Öffnungen 110 des Rahmenwafers 1 hindurch. Da sich vorliegend die Öffnungen 110 in Richtung von dem Abdeckplattenwafer 3 weg verjüngen, wird ein Teil dessen erster Hauptfläche 301 von den Öffnungen abgeschattet. Mit anderen Worten ist ein Teil der ersten Hauptfläche von dem Rahmenwafer 1 und von der Antireflex-Schicht unbedeckt.

Alternativ kann der Abdeckplattenwafer 3 vor dem Verbinden mit dem Rahmenwafer 1 mit der Antireflexschicht 4 beschichtet werden. Vorzugsweise werden dabei nur diejenigen Stellen der ersten Hauptfläche 301 beschichtet, die in der Verbindungsebene mit den Öffnungen 110 überlappen, wie im allgemeinen Teil beschrieben.

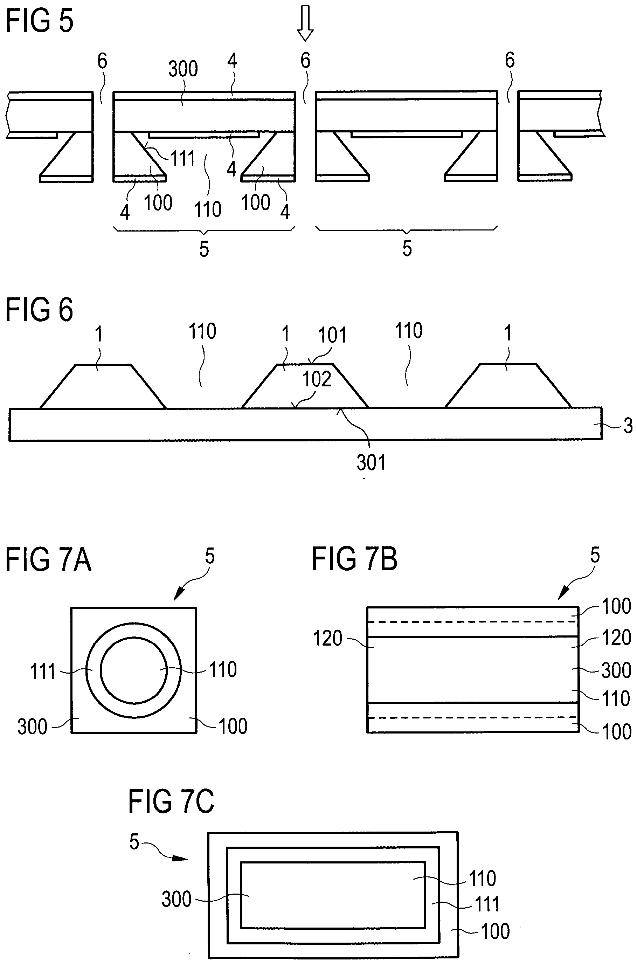

Schließlich wird der Verbund von Abdeckplattenwafer 3 und Rahmenwafer 1 zu einzelnen Abdeckelementen 5 vereinzelt. Dies erfolgt mit Schnitten 6 durch den Verbund, etwa mittels Sägen oder Lasertrennen. Der Verbund ist hierzu vorzugsweise auf einer in Figur 5 nicht gezeigten Sägefolie 6 angeordnet, welche insbesondere in einem Halterahmen gespannt ist.

Jedes der abgetrennten Abdeckelemente 5 weist eine Abdeckplatte 300 und ein Rahmenteil 100 auf. Die Abdeckplatte 300 ist ein Teilstück des Abdeckplattenwafers 3. Das Rahmenteil 100 ist ein Teilstück des Rahmenwafers 1, welches eine der Öffnungen 110 zumindest teilweise, vorliegend jedoch vollständig, enthält.

Figur 6 zeigt ein Stadium einer Variante des Verfahrens gemäß dem ersten Ausführungsbeispiel, das dem Stadium der Figur 3 entspricht, in einem schematischen Querschnitt. Bei der Variante des Verfahrens wird anstelle der ersten Hauptfläche 101 des Rahmenwafers 1 dessen zweite Hauptfläche 102 mit dem Abdeckplattenwafer 3 verbunden. Auf diese Weise werden Abdeckelemente 5 erzielt, bei denen sich die Querschnittsfläche der Öffnung 110 im Verlauf von der Abdeckplatte 300 weg vergrößert.

In den Figuren 7A-7C sind verschiedene Varianten der Geometrie von Öffnungen 110 in schematischen Draufsichten auf die Abdeckplatten 300 von Abdeckelementen 5 dargestellt.

Figur 7A zeigt ein Abdeckelement 5 mit rechteckiger oder quadratischer Grundfläche. Insbesondere haben die Abdeckplatte 300 und das Rahmenteil 100 in Draufsicht auf ihre Haupterstreckungsebenen eine rechteckige oder quadratische Grundfläche und sind vorzugsweise deckungsgleich angeordnet, das heißt derart angeordnet, dass ihre Außenkanten in Draufsicht zusammenfallen.

Die Öffnung 110 hat eine kreisförmige oder elliptische Querschnittsfläche. Die Querschnittsfläche verkleinert sich im Verlauf von der Abdeckplatte 300 weg. Die Öffnung 110 weist also die Form eines Kegelstumpfs auf.

Bei dem Abdeckelement 5 gemäß Figur 7B hat die Abdeckplatte 300 eine rechteckige Grundfläche. Das Rahmenteil 100 weist zwei Durchbrüche 120 auf. Genauer besteht es aus zwei Teilstücken, welche die Form von Stegen haben und parallel zu zwei gegenüberliegenden Kanten der Abdeckplatte 300 verlaufen. Zwischen den beiden Stegen erstreckt sich die streifenförmige Öffnung 110. In der Richtung, in welcher die Stege verlaufen, erstreckt sich die Öffnung 110 über die gesamte Länge des Abdeckelements.

Figur 7C zeigt eine schematische Draufsicht auf das Abdeckelement 5 der Figur 5 gemäß dem ersten Ausführungsbeispiel.

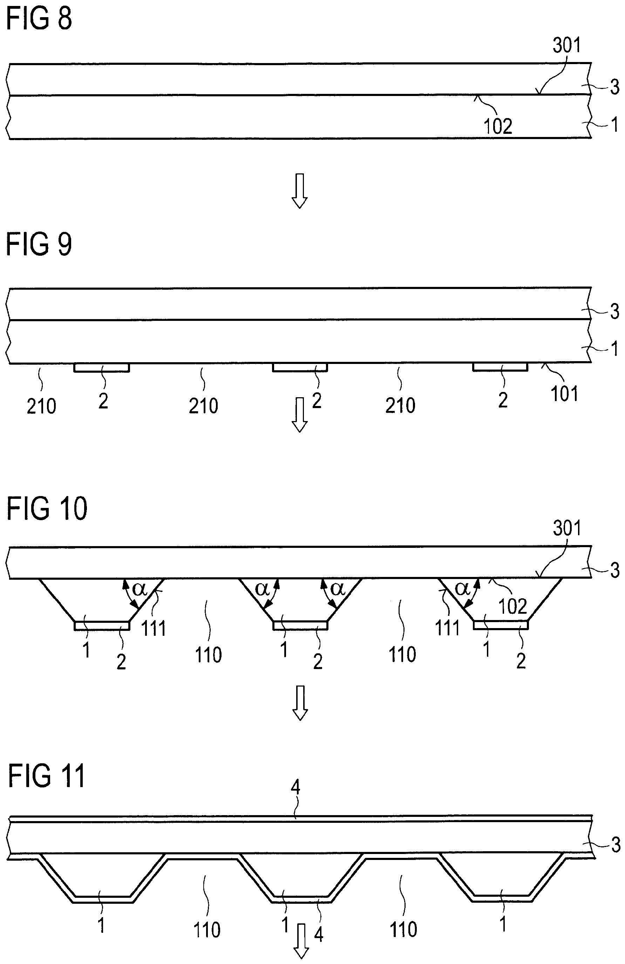

In den Figuren 8 bis 12 ist ein zweites Ausführungsbeispiel eines Verfahrens zur Herstellung eines Abdeckelements in schematischen Querschnitten dargestellt.

Es unterscheidet sich von dem ersten Ausführungsbeispiel darin, dass zunächst der Rahmenwafer 1 und der Abdeckplattenwafer 3 fügeschichtlos verbunden werden (siehe Fig. 8). Die fügeschichtlose Verbindung wird beispielsweise wie beim ersten Ausführungsbeispiel mittels anodischem Bonden hergestellt.

Die Herstellung der Öffnungen 110 im Rahmenwafer 1 erfolgt im Gegensatz zum ersten Ausführungsbeispiel erst nachfolgend auf die Verbindung von Rahmenwafer 1 und Abdeckplattenwafer 3. Hierzu wird, wie im ersten Ausführungsbeispiel, eine strukturierte Maskenschicht 2 auf die erste Hauptfläche 101 des Rahmenwafers 1 aufgebracht (siehe Fig. 9). Anschließend wird der Rahmenwafer 1 durch die Aussparungen 210 hindurch geätzt, beispielsweise wiederum mittels KOH oder TMAH, wobei die Öffnungen 110 entstehen (siehe Fig. 10).

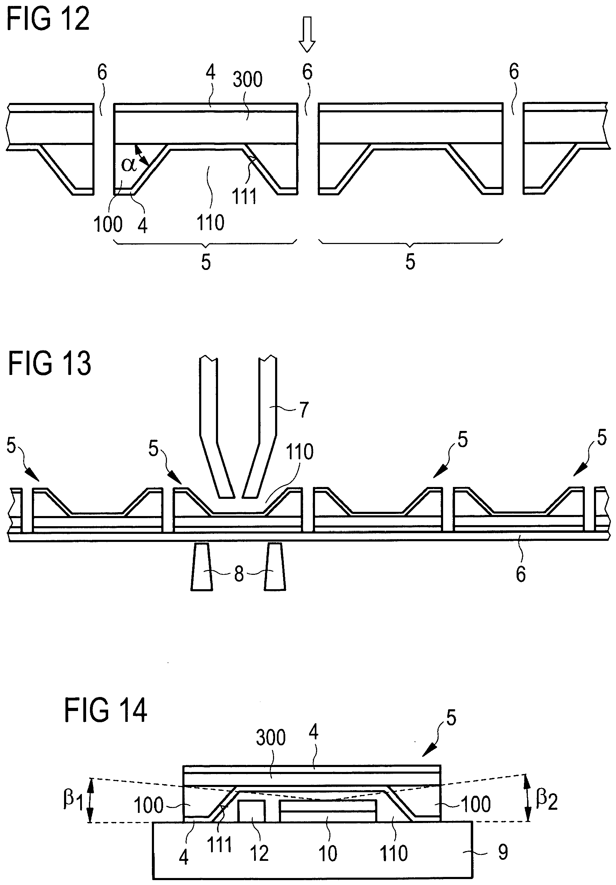

Analog zum ersten Ausführungsbeispiel erfolgt nachfolgend das optionale Entfernen der Maskenschicht 2. Im Anschluss wird der Verbund von Rahmenwafer 1 und Abdeckplattenwafer 3 beidseitig mit einer Antireflex-Schicht 4 versehen (siehe Fig. 11) und zu einer Mehrzahl von Abdeckelementen 5 vereinzelt (siehe Fig. 12).

Figur 13 zeigt einen Verfahrensschritt eines Ausführungsbeispiels eines Verfahrens zur Herstellung eines optoelektronischen Halbleitermoduls in einer schematischen Schnittdarstellung.

Beispielsweise folgt das in Figur 13 gezeigte Stadium des Verfahrens auf das Abtrennen des Abdeckelements 5 von dem Verbund aus Rahmenwafer 1 und Abdeckplattenwafer 3, etwa gemäß dem ersten Ausführungsbeispiel (siehe Figur 5) oder dem zweiten Ausführungsbeispiel (siehe Figur 12). Das Abdeckelement ist nach dem Abtrennen noch auf der Sägefolie 6 angeordnet. Vorliegend wird das Abdeckelement 5 mittels Ausstech-Spitzen 8 zumindest stellenweise von der Sägefolie 6 abgehoben, wodurch die Adhäsion zwischen Abdeckelement 5 und Sägefolie 6 vorteilhaft verringert ist.

Zur weiteren Verarbeitung wird das Abdeckelement mittels einer Saugnadel 7 von der Sägefolie 6 abgehoben.

Bei einer Ausgestaltung des Verfahrens ist die Abdeckplatte 300 der Sägefolie 3 zugewandt. Die Saugnadel 7 greift bei dieser Ausgestaltung zum Abheben des Abdeckelements von der Seite des Rahmenteils 100 her in die Öffnung 110 ein. Anschließend wird das Abdeckelement von der Saugnadel 7 an ein weiteres Werkzeug übergeben, welches das Abdeckelement 5 von der Seite der Abdeckplatte 300 her greift um es anschließend beispielsweise mit einem Chipträger 9 (siehe Figur 14) zu verbinden.

Mit einem solchen Verfahren, bei dem das Abdeckelement von einem Werkzeug von der Sägefolie 6 abgehoben und von einem anderen Werkzeug an der gewünschten Stelle positioniert wird, werden mit Vorteil eine hohe Genauigkeit der Positionierung und/oder hohe Taktraten und somit eine geringe Montagetoleranzen und/oder eine hohe Produktionsgeschwindigkeit erzielt.

In Figur 14 ist ein optoelektronisches Halbleitermodul gemäß einem dritten Ausführungsbeispiel in einem schematischen Querschnitt gezeigt. Das optoelektronische Halbleitermodul enthält ein Abdeckelement 5 gemäß dem zweiten Ausführungsbeispiel.

Das Abdeckelement 5 ist mit dem Chipträger 9 verbunden. Beispielsweise ist es mit diesem verlötet. Die Öffnung 110 stellt vorliegend einen von dem Abdeckelement 5 und dem Chipträger 9 vollständig umschlossenen Innenraum dar.

In dem Innenraum ist ein lichtemittierender Halbleiterchip 10, bei dem es sich vorliegend um einen Dünnfilm-Leuchtdiodenchip handelt, auf dem Chipträger 9 montiert und elektrisch mit Leiterbahnen einer Leiterbahnstruktur (nicht dargestellt) des Chipträgers 9 elektrisch kontaktiert.

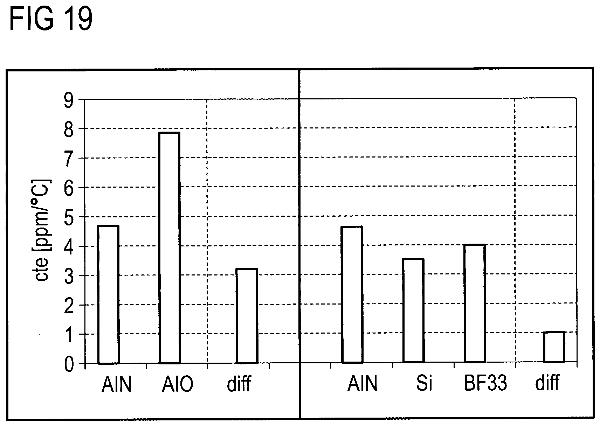

Der Chipträger 9 weist beispielsweise Aluminiumnitrid auf. In Figur 19 sind die Wärmeausdehnungskoeffizienten (cte) in Einheiten von ppm/°C, also 10⁻⁶/°C, von Aluminiumnitrid (AlN), Silizium (Si) und Borsilikatglas (BF33) dargestellt. Die Wärmeausdehnungskoeffizienten der Abdeckplatte 300 (BF33), des Rahmenteils 100 (Si) und des Chipträgers 9 (AlN) sind aufeinander abgestimmt. Die Differenz (diff) zwischen den Wärmeausdehnungskoeffizienten ist mit weniger als 1,5 x 10⁻⁶/°C sehr gering.

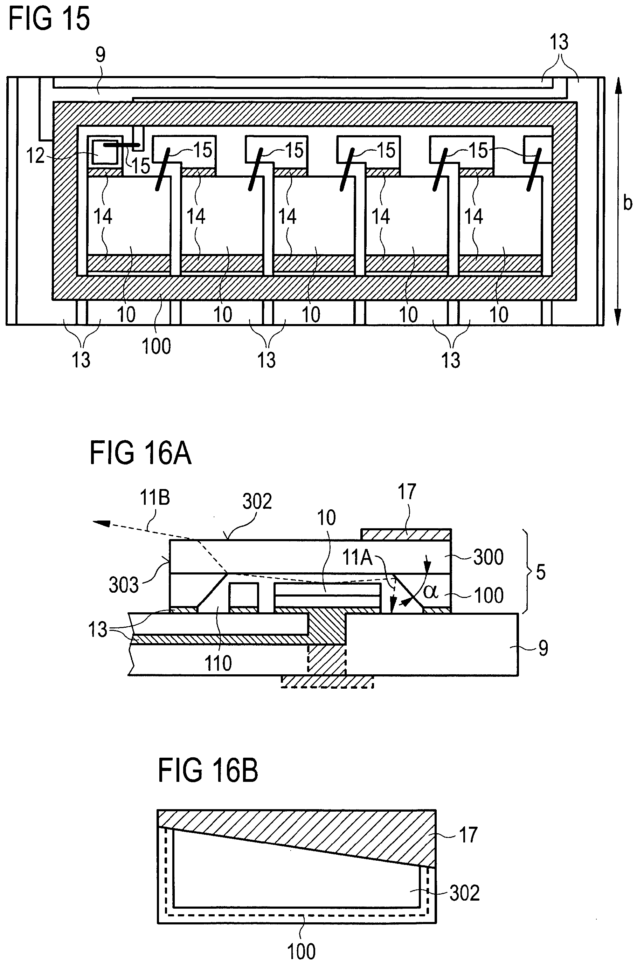

Das Rahmenteil 100 umschließt vorliegend den Halbleiterchip 10 in Draufsicht auf den Chipträger 9 vollständig. Die Querschnittsfläche der Öffnung 110 verkleinert sich in Richtung von dem Chipträger 9 zu der Abdeckplatte 300 hin. Anders ausgedrückt nimmt ein lateraler Abstand zwischen dem Halbleiterchip 10 und einer, insbesondere jeder, der Seitenflächen 111 der Öffnung 110 in Richtung von dem Chipträger 9 zu der Abdeckplatte 300 hin ab. Die Seitenflächen 111 schatten gezielt einen definierten Teil des von dem Halbleiterchip 10 im Betrieb emittierten Lichts ab. Ein abgeschatteter Lichtstrahl 11A ist bei dem Halbleitermodul gemäß Figur 16 exemplarisch dargestellt. Insbesondere wird Licht abgeschattet, das von dem Halbleiterchip 10 unter einem Winkel zur Haupterstreckungsebene des Chipträgers 9 emittiert wird, der kleiner ist als ein Grenzwinkel *β*.

Vorliegend enthält der Innenraum neben dem lichtemittierenden Halbleiterchip 10 ein weiteres elektronisches Bauelement 12. Beispielsweise handelt es sich bei diesem um eine Schutzdiode, welche die Gefahr einer Beschädigung des Halbleiterbauelements durch eine elektrostatische Entladung verringert. Beispielsweise aufgrund des in dem Innenraum angeordneten elektronischen Bauelements 12 ist der Halbleiterchip 10 nicht mittig zwischen zwei Seitenwänden 111 der Öffnung 110 platziert, so dass sich zwei unterschiedliche Grenzwinkel *β*, nämlich die Grenzwinkel *β*₁ und *β*₂, auftreten, je nachdem ob der Halbleiterchip 10 Licht in Richtung weiter entfernten Seitenwand (*β*₁) oder der gegenüberliegenden, näher an dem Halbleiterchip angeordneten Seitenwand (*β*₂) emittiert. Vorliegend haben die Grenzwinkel einen Wert von *β*₁ = 6° und *β*₂ = 8°.

Das Rahmenteil ist vorliegend mit Vorteil so ausgeführt, dass die Seitenflanken 303 der Abdeckplatte 300 nicht von dem vom Halbleiterchip 10 emittierten Licht beleuchtet werden. Das Licht wird stattdessen durch die von dem Halbleiterchip abgewandte zweite Hauptfläche 302 der Abdeckplatte 300 aus dem Halbleitermodul ausgekoppelt. Dies ist bei dem Halbleitermodul gemäß Figur 16 durch den Lichtstrahl 11B exemplarisch dargestellt.

In Figur 15 ist eine schematische Draufsicht auf das Halbleitermodul gemäß dem dritten Ausführungsbeispiel gezeigt.

Das Halbleitermodul enthält eine Mehrzahl von lichtemittierenden Halbleiterchips 10, vorliegend enthält es fünf lichtemittierende Halbleiterchips 10, die gemeinsam in der Öffnung 110 angeordnet sind. Die Halbleiterchips 10 sind beispielsweise mittels der Bonddrähte 15 in Serie geschaltet. Bei einer Ausgestaltung sind die Halbleiterchips 10 in einer Reihe angeordnet. Beispielsweise bei dieser Ausgestaltung hat der Chipträger 9 eine Breite b von 4 mm oder weniger, beispielsweise von etwa 3,6 mm. Die Halbleiterchips 10 haben beispielsweise eine Breite von etwa 2,1 mm. Die Breite ist dabei vorliegend die Abmessung quer zur Richtung der Reihe.

Jeder Halbleiterchip 10 ist auf eine Leiterbahn 13 des Chipträgers 9 gelötet. Lötbarrieren 14 auf den Leiterbahnen 13 verringern die Gefahr, dass sich beim Löten Lot über einen zu großen Bereich der Leiterbahn 13 verteilt. Insbesondere begrenzen die Lötbarrieren 14 das Lot im Wesentlichen auf den von dem Halbleiterchip 10 bedeckten Bereich der Leiterbahn 13. Die Lötbarrieren 14 weisen beispielsweise eine Schicht aus einem hydrophoben Material auf, etwa eine Cr-Schicht, oder bestehen daraus.

In den Figuren 16A und 16B ist eine Variante des optoelektronischen Halbleitermoduls gemäß dem dritten Ausführungsbeispiel schematisch im Querschnitt dargestellt.

Das Halbleitermodul gemäß den Figuren 16A und 16B unterscheidet sich von demjenigen der Figuren 14 und 15 zum einen dadurch, dass auf der vom Halbleiterchip 10 abgewandten Hauptfläche 302 der Abdeckplatte 300 stellenweise eine reflektierende Schicht 17 aufgebracht ist, die einen weiteren Teil des von dem Halbleiterchip 10 emittierten Lichts gezielt abschattet. Beispielsweise wird mittels der reflektierenden Schicht 17 eine asymmetrische Geometrie des Lichtauskoppelbereichs der Abdeckplatte 300 erzielt, wie dies in Figur 16B in Draufsicht schematisch gezeigt ist.

Zum anderen unterscheidet sich das Halbleitermodul gemäß Figuren 16A und 16B von dem der Figuren 14 und 15 dadurch, dass der Chipträger 9 eine Mehrschichtstruktur aufweist. Insbesondere verläuft eine den Halbleiterchip kontaktierende Leiterbahn 13 stellenweise im Inneren des Chipträgers 9. Auf diese Weise wird eine vollständig umlaufende Befestigung des Rahmenteils 100 an dem Chipträger 9 erzielt. Eine Unterbrechung der Befestigung, um die elektrischen Anschlüsse für den Halbleiterchip 10 aus dem Innenraum 110 heraus zu führen ist mit Vorteil nicht notwendig. Der Innenraum ist daher besonders gut abgedichtet.

Die im Inneren des Chipträgers 9 verlaufende Leiterbahn 13 ist bei einer Ausführungsform seitlich vom Abdeckelement 5 wieder auf die Vorderseite des Chipträgers 9 geführt, auf dem der Halbleiterchip 5 und das Abdeckelement 5 montiert sind. Bei einer anderen Ausführungsform ist die Leiterbahn auf die der Vorderseite gegenüberliegende Rückseite geführt, wie in Figur 16A mit gestrichelten Linien angedeutet.

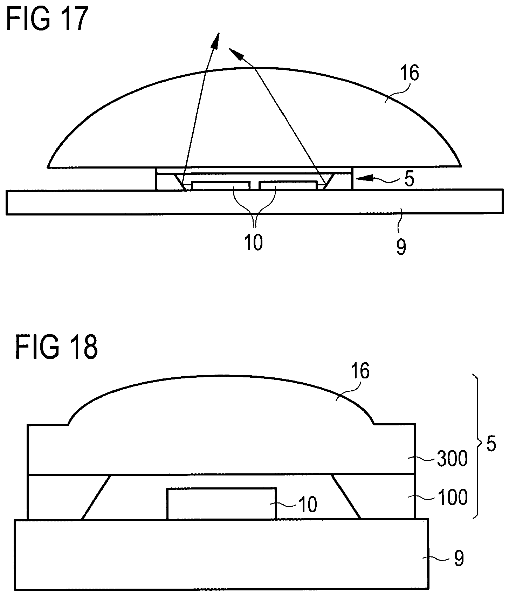

Das optoelektronische Halbleitermodul gemäß dem in Figur 17 schematisch im Querschnitt dargestellten vierten Ausführungsbeispiel weist zusätzlich zu den Halbleitermodulen gemäß den vorhergehenden Ausführungsbeispielen ein Strahlformungselement 16, vorliegend eine Linse, insbesondere eine Konvexlinse, auf. Das Strahlformungselement 16 ist beispielsweise auf die Abdeckplatte 300 geklebt.

Bei dem in Figur 18 schematisch im Querschnitt dargestellten fünften Ausführungsbeispiel eines optoelektronischen Halbleiterbauelements ist das Strahlformungselement als mit der Abdeckplatte integriert ausgebildetes, vorliegend konvexes Linsenelement 16 ausgeführt.

Die Erfindung ist nicht durch die Beschreibung anhand der Ausführungsbeispiele auf diese beschränkt. Vielmehr ist die Erfindung in den Patentansprüchen definiert.

## Patentansprüche

1. Optoelektronisches Halbleitermodul mit
- einem Chipträger (9),
- einem auf dem Chipträger (9) montierten lichtemittierenden und/oder lichtempfangenden Halbleiterchip (10) und
- einem Abdeckelement, das eine zumindest teilweise lichtdurchlässige Abdeckplatte (300), die auf der von dem Chipträger (9) abgewandten Seite des Halbleiterchips (10) angeordnet ist, und ein Rahmenteil (100) aufweist, wobei das Rahmenteil (100) den Halbleiterchip (10) seitlich umgibt und an seiner von der Abdeckplatte (300) entfernten Seite mit dem Chipträger (9) verbunden ist, **dadurch gekennzeichnet, dass**
- der Chipträger (9) Aluminiumnitrid enthält,
- das Rahmenteil (100) fügeschichtlos mit der Abdeckplatte (300) verbunden ist, so dass eine Hauptfläche (101) des Rahmenteils (100) und eine Hauptfläche (301) der Abdeckplatte (300) in einer gemeinsamen Verbindungsebene enthalten sind, und
- die Abdeckplatte (300) stellenweise mit einer reflektierenden und/oder absorbierenden Schicht (17) versehen ist, mittels deren eine asymmetrische Geometrie des Lichtauskoppelbereichs der Abdeckplatte (300) erzielt wird.

2. Optoelektronisches Halbleitermodul gemäß Anspruch 1, bei dem
das Rahmenteil (100) mindestens eine dem Halbleiterchip (10) zugewandte schräge Seitenfläche (111) aufweist.

3. Optoelektronisches Halbleitermodul gemäß Anspruch 2, bei dem
sich ein lateraler Abstand zwischen der schrägen Seitenfläche (111) und dem Halbleiterchip (10) im Verlauf von dem Chipträger (9) zur Abdeckplatte (300) hin verkleinert oder vergrößert.

4. Optoelektronisches Halbleitermodul gemäß einem der Ansprüche 1 bis 3, bei dem
das Rahmenteil (100) an den Chipträger (9) gelötet ist.

5. Optoelektronisches Halbleitermodul gemäß einem der Ansprüche 1 bis 4, bei dem
ein von dem Abdeckelement und dem Chipträger (9) umschlossener Bereich, der den Halbleiterchip (10) enthält, frei von einer den Halbleiterchip verkapselnden Vergussmasse ist.

6. Optoelektronisches Halbleitermodul gemäß einem der Ansprüche 1 bis 5, bei dem
eine Mehrzahl von lichtemittierenden Halbleiterchips (10) in einer von dem Rahmenteil (100) gebildeten Öffnung (110) angeordnet ist und
jeder Halbleiterchip (10) auf eine Leiterbahn (13) des Chipträgers (9) gelötet ist.

7. Optoelektronisches Halbleitermodul gemäß einem der Ansprüche 1 bis 6, bei dem
die Abdeckplatte (300) Borsilikatglas und das Rahmenteil (100) Silizium enthält.

8. Optoelektronisches Halbleitermodul gemäß einem der Ansprüche 1 bis 7, das im Betrieb Lichtstrahlen aussendet und/oder empfängt, die mit der Haupterstreckungsebene des Chipträgers (9) einen Winkel von kleiner oder gleich 10° einschließen.

9. Kraftfahrzeugscheinwerfer mit einem optoelektronischen Halbleitermodul gemäß einem der Ansprüche 1 bis 8.

10. Projektionsvorrichtung mit einem optoelektronischen Halbleitermodul gemäß einem der Ansprüche 1 bis 8.

11. Verfahren zum Herstellen eines optoelektronischen Halbleitermoduls mit den Schritten:
- Bereitstellen eines lichtdurchlässigen Abdeckplattenwafers (3) und eines Rahmenwafers (1);
- Herstellen einer Öffnung (110) in dem Rahmenwafer (1);
- fügeschichtloses Befestigen des Rahmenwafers (1) an dem Abdeckplattenwafer (3) mittels des Verfahrens des anodischen Bondens, so dass eine Hauptfläche des Rahmenwafers (1) und eine Hauptfläche des Abdeckplattenwafers (3) in einer gemeinsamen Verbindungsebene enthalten sind;
- Abtrennen eines Abdeckelements aus dem Verbund von Rahmenwafer (1) und Abdeckplattenwafer (3), wobei ein abgetrenntes Teilstück des Abdeckplattenwafers (3) eine Abdeckplatte (300) des Abdeckelements bildet, ein abgetrenntes Teilstück des Rahmenwafers (1) die Öffnung (110) zumindest teilweise enthält und ein mit der Abdeckplatte (300) verbundenes Rahmenteil (100) des Abdeckelements bildet, und das Teilstück des Abdeckplattenwafers (3), welches die Abdeckplatte (300) bildet, stellenweise mit einer reflektierenden und/oder absorbierenden Schicht (17) versehen wird, mittels deren eine asymmetrische Geometrie des Lichtauskoppelbereichs der Abdeckplatte (300) erzielt wird;
- Montieren eines lichtemittierenden und/oder lichtempfangenden Halbleiterchips (10) auf einem Chipträger (9), der Aluminiumnitrid enthält;
- Befestigen des Rahmenteils (100) an dem Chipträger (9), derart, dass das Rahmenteil (100) den Halbleiterchip (10) lateral umgibt und der Halbleiterchip (10) zwischen der Abdeckplatte (300) und dem Chipträger (9) angeordnet ist.

12. Verfahren nach Anspruch 11, bei dem die Öffnung (110) in einer Mehrzahl von Öffnungen (110) durch Ätzen des Rahmenwafers (1) hergestellt wird und das Befestigen des Rahmenwafers (1) an dem Abdeckplattenwafer (3) mittels eines anodischen Bondprozesses nach dem Ätzen der Öffnungen (110) erfolgt.

13. Verfahren nach Anspruch 11 oder 12, bei dem das Herstellen der Öffnung (110) ein anisotropes nass- und/oder trockenchemisches Ätzverfahren und/oder ein Sandstrahlverfahren umfasst.

## Claims

1. Optoelectronic semiconductor module having
- a chip carrier (9),
- a light-emitting and/or light-receiving semiconductor chip (10) mounted on the chip carrier (9) and
- a cover element, which comprises an at least partially light-transmitting cover plate (300), which is arranged on the side of the semiconductor chip (10) remote from the chip carrier (9), and a frame part (100), the frame part (100) laterally surrounding the semiconductor chip (10) and being connected on its side remote from the cover plate (300) to the chip carrier (9), **characterized in that**
- the chip carrier (9) contains aluminum nitride,
- the frame part (100) is connected without a joining layer to the cover plate (300), such that a major face (101) of the frame part (100) and a major face (301) of the cover plate (300) are contained in a common connection plane, and
- the cover plate (300) is provided in places with a reflective and/or absorbing layer (17), by means of which an asymmetric geometry of the light outcoupling region of the cover plate (300) is achieved.

2. Optoelectronic semiconductor module according to claim 1, in which
the frame part (100) comprises at least one oblique side face (111) facing the semiconductor chip (10).

3. Optoelectronic semiconductor module according to claim 2, in which
a lateral distance between the oblique side face (111) and the semiconductor chip (10) reduces or increases from the chip carrier (9) towards the cover plate (300).

4. Optoelectronic semiconductor module according to one of claims 1 to 3, in which
the frame part (100) is soldered to the chip carrier (9).

5. Optoelectronic semiconductor module according to one of claims 1 to 4, in which
a region enclosed by the cover element and the chip carrier (9), which region contains the semiconductor chip (10), is free of a potting compound encapsulating the semiconductor chip.

6. Optoelectronic semiconductor module according to one of claims 1 to 5, in which
a plurality of light-emitting semiconductor chips (10) is arranged in an opening (110) formed by the frame part (100) and
each semiconductor chip (10) is soldered to a conductor track (13) of the chip carrier (9).

7. Optoelectronic semiconductor module according to one of claims 1 to 6, in which
the cover plate (300) contains borosilicate glass and the frame part (100) contains silicon.

8. Optoelectronic semiconductor module according to one of claims 1 to 7, which, when in operation, emits and/or receives beams of light which form an angle of less than or equal to 10° with the main plane of extension of the chip carrier (9).

9. Automotive headlight having an optoelectronic semiconductor module according to one of claims 1 to 8.

10. Projection apparatus having an optoelectronic semiconductor module according to one of claims 1 to 8.

11. Method for producing an optoelectronic semiconductor module having the steps:
- providing a light-transmitting cover plate wafer (3) and a frame wafer (1);
- producing an opening (110) in the frame wafer (1);
- fastening the frame wafer (1) to the cover plate wafer (3) without a joining layer using the anodic bonding method, such that a major face of the frame wafer (1) and a major face of the cover plate wafer (3) are contained in a common connection plane;
- separating a cover element from the assembly of frame wafer (1) and cover plate wafer (3), wherein a separated portion of the cover plate wafer (3) forms a cover plate (300) of the cover element, a separated portion of the frame wafer (1) at least partially contains the opening (110) and forms a frame part (100) of the cover element connected to the cover plate (300), and the portion of the cover plate wafer (3) which forms the cover plate (300) is provided in places with a reflective and/or absorbing layer (17), by means of which an asymmetric geometry of the light outcoupling region of the cover plate (300) is achieved;
- mounting a light-emitting and/or light-receiving semiconductor chip (10) on a chip carrier (9) which contains aluminum nitride;
- fastening the frame part (100) to the chip carrier (9) in such a way that the frame part (100) laterally surrounds the semiconductor chip (10) and the semiconductor chip (10) is arranged between the cover plate (300) and the chip carrier (9).

12. Method according to claim 11, in which the opening (110) is produced in a plurality of openings (110) by etching of the frame wafer (1), and fastening of the frame wafer (1) to the cover plate wafer (3) proceeds by means of an anodic bonding process after etching of the openings (110).

13. Method according to claim 11 or 12, in which production of the opening (110) comprises an anisotropic wet and/or dry chemical etching method and/or a sand blasting method.

## Revendications

1. Module optoélectronique à semi-conducteur comprenant
- un support de puce (9),
- une puce à semi-conducteur (10) émettrice de lumière et/ou réceptrice de lumière, montée sur le support de puce (9) et
- un élément de recouvrement qui présente une plaque de recouvrement (300) au moins en partie perméable à lumière, laquelle est disposée sur le côté de la puce à semi-conducteur, détourné du support de puce (9), et une partie en cadre (100), la partie en cadre (100) entourant latéralement la puce à semi-conducteur (10) et étant reliée au support de puce (9) sur son côté éloigné de la plaque de recouvrement (300), **caractérisé en ce que**
- le support de puce (9) contient du nitrure d'aluminium,
- **en ce que** la partie en cadre (100) est reliée à la plaque de recouvrement (300) en étant exempte de couche de jonction, de sorte qu'une surface principale (101) de la partie en cadre (100) et qu'une surface principale (301) de la plaque de recouvrement (300) sont contenues dans un plan de liaison commun, et **en ce que**
- la plaque de recouvrement (300) est munie par endroits d'une couche (17) réfléchissante et/ou absorbante, au moyen de laquelle une géométrie asymétrique de la zone de découplage de lumière de la plaque de recouvrement (300) est obtenue.

2. Module optoélectronique à semi-conducteur selon la revendication 1, dans lequel
la partie en cadre (100) présente au moins une surface latérale oblique (111) tournée vers la puce à semi-conducteur (10).

3. Module optoélectronique à semi-conducteur selon la revendication 2, dans lequel
un écart latéral entre la surface latérale oblique (111) et la puce à semi-conducteur (10) diminue ou augmente dans l'étendue en direction allant du support de puce (9) vers la plaque de recouvrement (300).

4. Module optoélectronique à semi-conducteur selon l'une quelconque des revendications 1 à 3, dans lequel la partie en cadre (100) est soudée sur le support de puce (9).

5. Module optoélectronique à semi-conducteur selon l'une quelconque des revendications 1 à 4, dans lequel une zone enfermée par l'élément de recouvrement et le support de puce (9), laquelle contient la puce à semi-conducteur (10), est exempte d'une masse de scellement encapsulant la puce à semi-conducteur.

6. Module optoélectronique à semi-conducteur selon l'une quelconque des revendications 1 à 5, dans lequel une pluralité de puces à semi-conducteur (10) émettrices de lumière sont disposées dans une ouverture (110) formée par la partie en cadre (100), et
dans lequel chaque puce à semi-conducteur (10) est soudée sur une piste conductrice (13) du support de puce (9).

7. Module optoélectronique à semi-conducteur selon l'une quelconque des revendications 1 à 6, dans lequel la plaque de recouvrement (300) contient du verre de borosilicate, et dans lequel la partie en cadre (100) contient du silicium.

8. Module optoélectronique à semi-conducteur selon l'une quelconque des revendications 1 à 7, lequel émet et/ou reçoit des rayons lumineux en fonctionnement, lesquels, avec le plan d'étendue principale du support de puce (9), comprennent un angle inférieur ou égal à 10°.

9. Projecteur de véhicule automobile comprenant un module optoélectronique à semi-conducteur selon l'une quelconque des revendications 1 à 8.

10. Dispositif de projection comprenant un module optoélectronique à semi-conducteur selon l'une quelconque des revendications 1 à 8.

11. Procédé de fabrication d'un module optoélectronique à semi-conducteur, comprenant les étapes:
- mise à disposition d'une tranche (3) de plaque de recouvrement perméable à lumière et d'une tranche (1) de cadre;
- fabrication d'une ouverture (110) dans la tranche (1) de cadre;
- fixation, exempte de couche de jonction, de la tranche (1) de cadre sur la tranche (3) de plaque de recouvrement au moyen du procédé de liaison anodique, de sorte qu'une surface principale de la tranche (1) de cadre et qu'une surface principale de la tranche (3) de plaque de recouvrement soient contenues dans un plan de liaison commun ;
- séparation d'un élément de recouvrement hors de l'ensemble tranche (1) de cadre et tranche (3) de plaque de recouvrement, une section séparée de la tranche (3) de plaque de recouvrement formant une plaque de recouvrement (300) de l'élément de recouvrement, une section séparée de la tranche (1) de cadre contenant au moins en partie l'ouverture (110) et formant une partie de cadre (100) de l'élément de recouvrement, reliée à la plaque de recouvrement (300), et la section de la tranche (3) de plaque de recouvrement, laquelle forme la plaque de recouvrement (300), étant munie par endroits d'une couche (17) réfléchissante et/ou absorbante, au moyen de laquelle une géométrie asymétrique de la zone de découplage de lumière de la plaque de recouvrement (300) est obtenue ;
- montage d'une puce à semi-conducteur (10) émettrice de lumière et/ou réceptrice de lumière sur un support de puce (9) qui contient du nitrure d'aluminium ;
- fixation de la partie en cadre (100) sur le support de puce (9) de manière à ce que la partie en cadre (100) entoure latéralement la puce à semi-conducteur (10) et que la puce à semi-conducteur (10) soit disposée entre la plaque de recouvrement (300) et le support de puce (9).

12. Procédé selon la revendication 11, dans lequel l'ouverture (110) est fabriquée dans une pluralité d'ouvertures (110) par gravure de la tranche (1) de cadre et dans lequel la fixation de la tranche (1) de cadre sur la tranche (3) de plaque de recouvrement est réalisée au moyen d'un processus de liaison anodique après la gravure des ouvertures (110).

13. Procédé selon la revendication 11 ou 12, dans lequel la fabrication de l'ouverture (110) comprend un procédé de gravure anisotrope à chimie humide et/ou sèche et/ou un procédé à jet de sable.
